(19)

Europäisches
Patentamt

European
Patent Office

Office européen
des brevets

(11) **EP 4 567 765 A1**

(12) **EUROPEAN PATENT APPLICATION**

(43) Date of publication:
**11.06.2025 Bulletin 2025/24**

(21) Application number: **23383257.5**

(22) Date of filing: **05.12.2023**

(51) International Patent Classification (IPC):
**G08G 1/01** *(2006.01)* **G06F 30/20** *(2020.01)*

(52) Cooperative Patent Classification (CPC):
**G08G 1/0129; G06F 30/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **FUJITSU LIMITED
Kawasaki-shi, Kanagawa 211-8588 (JP)**

(72) Inventor: **PEÑA MUÑOZ, Manuel
28400 Collado Villalba (Madrid) (ES)**

(74) Representative: **Haseltine Lake Kempner LLP
Cheapside House
138 Cheapside
London EC2V 6BJ (GB)**

(54) **A COMPUTER-IMPLEMENTED METHOD FOR PREDICTING EVOLUTION OF TRAFFIC SIMULATIONS**

(57)    A computer-implemented method for predicting evolution of a traffic simulation, the method comprising: accepting input of traffic data comprising data obtained from sensors in a geographic region; executing a traffic simulation using the traffic data for the geographic region; responsive to a decision to model the effects of a modification to the traffic simulation, selecting an intervention from a plurality of potential interventions; modifying parameters of the traffic simulation using the intervention to obtain modified simulation parameters; and executing a modified traffic simulation using the modified simulation parameters, the modified traffic simulation being configured to reflect the effect of the intervention on traffic.

| Accept input of traffic data comprising data obtained from sensors in a geographic region. | S11 |

| Execute a traffic simulation using the traffic data for the geographic region. | S12 |

| Responsive to a decision to model the effects of a modification to the traffic simulation, select an intervention from a plurality of potential interventions. | S13 |

| Modify parameters of the traffic simulation using the intervention to obtain modified simulation parameters. | S14 |

| Execute a modified traffic simulation using the modified simulation parameters, the modified traffic simulation being configured to reflect the effect of the intervention on traffic. | S15 |

Figure 1

## Description

### Field of the Invention

The present invention relates to traffic simulations. More particularly, the present invention relates to a method for predicting the evolution of traffic simulations and related data processing apparatuses, computer programs, and computer-readable storage media.

### Background of the Invention

There exists a trend where the real world may be represented as a digital world. Concepts such as Smart Cities, Digital Twins (DTs), and the Metaverse have received particular attention, at least in part due to the new and improved technologies that enable advancements within these concepts, such as technologies related to Internet of Things (IoT), 5th Generation technology standard for telecommunications (5G), Artificial Intelligence (AI), and quantum computing, among others.

For improvements related to transport, smart traffic systems are used to deliver a wide range of services to varied users at scale and in real time (or at least fast enough for effective action to be taken). It is desirable for systems to deliver a wide range of services, created by complex processing of primarily real-time sensed data acquired from sources in (or serving) a transport network (for example, from roads and from vehicles). The services are often required in "real time", such that immediate action to be taken by the users of the services. There are diverse data sources, generating different types of data at different rates. The services are also diverse and complex, using the data in a wide range of different ways.

As an example, a transport authority for a large city may create a simulation in the form of a system DT of its public transport infrastructure that provides a real-time virtual model of the flow of traffic throughout the city. The virtual model may be driven by data generated from a wide variety of sources in real time, including: vehicle movements from in-vehicle GPS, roadside sensors, CCTV analysis, routing requests, live dispatches of public transport, etc.; the state and operation of infrastructure, such as traffic lights; and movements of people, from mobile GPS, ticketing activity, CCTV, etc.

System DTs (virtual models of the system) integrate data sources and provide real-time understanding of the state of traffic flow. Synchronous services may be added to the DT, for instance using anomaly detection methods to determine incidents (accidents, congestion, etc.). However, there is also the need to manage such incidents, for example to divert traffic around accidents, deploy emergency services, and/or to reroute public transport.

A requirement of smart transport systems is to predict the state of the system and so enable services. Conventional simulations used for prediction of traffic are, however, typically fixed in terms of goals and behaviours. Conventional simulations are neither sufficiently predictive nor sufficiently adaptive to accommodate potential scenarios that are not modelled by the original simulation. Rather, such techniques simply emulate modelled scenarios. To simulate new behaviours, a completely new simulation model must be created, which is computationally arduous and takes a long period of time to prepare and initiate. This is not optimal for real time environments.

Modern techniques that have been developed to address this issue include deep learning (DL) simulation modelling, which utilises machine learning models that are adaptive. These are, however, reliant on well-constructed training datasets, which are laborious to prepare. The intentions of the DL simulation (the effects of the new behaviours on the simulated system) are, in effect, fixed to the training dataset; if the behaviour is out of domain, the intention will not evolve. Moreover, the training of such specific models is computationally expensive, and simulation models must handle high volumes of varied data.

The inventors have therefore come to the realisation that techniques are required that provide improvements in realistic simulations of scenarios in digital representations of the real world.

### Summary of the Invention

The invention is defined in the independent claims, to which reference should now be made. Further features are set out in the dependent claims.

According to an aspect of the invention, there is provided a computer-implemented method for predicting evolution of a traffic simulation. The method includes a step of accepting input of traffic data. The traffic data may be vehicular data and/or pedestrian data. The traffic data includes data that is obtained from one or more sensors within a given geographic region (the region of the traffic simulation). The traffic data may further include data related to current or upcoming weather, seasonality, prearranged events (such as concerts or sporting events), mobility flow, and correlated patterns in traffic from other geographic regions (adjacent geographic regions and non-adjacent geographic regions).

The method includes a step of executing the traffic simulation using the traffic data for the given region. In this way, a traffic forecast may be generated, which may illustrate the manner in which traffic patterns within the geographic region evolve. Any known traffic simulation technique may be used for this purpose.

The method includes execution of a decision process, where a decision is made as to whether to model or simulate the effects of a modification or intervention to the traffic simulation. For example, a decision may be made to model the effects of an intervention in the event that a forecast of the simulated behaviour provides abnormal traffic behaviour. In response to a positive decision, the method includes selecting an intervention from amongst multiple potential interventions to apply to the traffic within the simulation.

The method includes a step of modifying parameters of the traffic simulation in light of the selected intervention. In this way, the method obtains modified simulation parameters. The modified simulation parameters are configured to cause a simulation to reflect the effect (or effects) of the selected intervention on the traffic.

The method then includes a step of executing a modified traffic simulation. The modified traffic simulation uses the modified simulation parameters and may further use the traffic data as obtained from the sensors in the geographic region of interest. In this way, the method may generate a modified traffic forecast, which reflects the effect of the selected intervention on the traffic.

Vehicular traffic and human traffic behavioural models play an important role in the field of DTs and will benefit future, for instance, metaverse solutions. The techniques herein provide realistic future simulations that are predictive and adaptive to account for abnormal or unexpected future scenarios.

Techniques herein provide a system able to adapt and evolve intentions in current simulation systems, and thereby provide more realistic behaviours. The techniques provide predictive and adaptive simulations for abnormal and forecasted scenarios in DTs, and enable smart decision-making for anticipating potential new behaviours of the simulation given new contexts in DTs.

The method herein may be applied to agent-based modelling systems (ABMSs), in which simulation of the actions and interactions of autonomous agents (both individual or collective entities such as organisations or groups) enable understanding of the behaviour of the traffic system. Broadly, agents of an ABMS may have their own preprogrammed goals and the system as a whole may have a preprogrammed goal. Agents may be interconnected with other agents, and each may be implemented as a software module or bot. In a traffic scenario, one agent may be representative of a traffic intersection, or an individual vehicle. In ABMSs used for simulation, the intentions of the modelled behaviours do not evolve with time. Consequently, every time that a behaviour needs to be incorporated into the simulation, a new ABMS model needs to be created, which is not efficient.

The method provides accurate and realistic simulations, which recreate future behaviours based on potential events (interventions) that affect the real-world behaviour of the underlying system. The method offers and integrates smart decision-making in current scenarios, which enables the application of potential countermeasures so as to minimise the potential impact of upcoming scenarios. In effect, the method enables digital rehearsals with interventions.

The technique herein offers predictability through providing awareness of upcoming scenarios that potentially could affect to current recreation of future behaviours. And the technique offers adaptability, enabling adaptive simulations for potentially abnormal and forecasted upcoming scenarios as quickly as required by the user.

The method for predicting evolution of a traffic simulation enhances realistic representation in simulated scenarios of traffic simulations, including human mobility. Therefore, the method is applicable to any field where a traffic simulation is required and to any other scenario where people mobility flow may be recreated.

Optionally, the method may include a step of outputting instructions to be applied to the real-world geographic region (upon which the simulation and intervention are based). For instance, following simulation of a given intervention, in the event that the effect of the intervention is desirable (e.g., a significant reduction in traffic congestion), computational means implementing the method may output instructions to implement the given intervention.

Optionally, the decision to model the effects of the modification to the traffic simulation may include a step of identifying an upcoming event in the traffic simulation. The upcoming event may be identified based on the sensor data and/or based on extrapolation of the traffic simulation from its current state. The method may then include a step of forecasting the impact of the upcoming event on the traffic simulation. When the impact exceeds a predetermined threshold, the method may include a step of deciding to model the effects of the modification to the traffic simulation.

As a simple example, sensor data may indicate that the number of cars joining a road in the geographic region is steadily increasing while the number of cars exiting the road remains steady; forecasting or extrapolating will indicate that the number of cars on the given road will increase. When the number of cars exceeds a given predetermined number of cars deemed to be safely accommodated on the road, a decision may be made to model the effects of some modification or intervention to a simulation representative of the scenario. As another example, sensor data may be used to monitor pedestrian activity in and around a concert or sporting event within a geographic region. A conventional traffic simulation with fixed parameters is unable to capture the impact on surrounding roads and pedestrian thoroughfares. In contrast, forecasting or extrapolating may predict that the geographic region is likely to be very crowded and the implementing computing system may then decide that the simulation needs to be "corrected" through an intervention.

In effect then, the method may involve execution of three simulations (or aspects thereof): simulation of "regular" behaviour using initial conditions; simulation (or forecasting) of the modified behaviour, due to a forecasted change of the initial conditions simulated; and simulation of the countermeasure of the intervention, found for a concrete target (e.g.,

reduce emission output, reduce traffic congestion, optimise road capacity, etc.) and simulated so as to see the impact of the selected intervention.

Optionally, selecting the intervention from amongst the multiple potential interventions includes a step of determining the scope of the traffic simulation to be subject to the intervention. The scope may be any or all of, for instance: a sub-region of the geographic region of interest; a time period or timescale for which the intervention may be applied or in effect; and the modality of traffic to be directly impacted by the intervention (of course, other modalities may be indirectly impacted). The method then includes a step of calculating a plurality of scores, where each score corresponds to one of the potential interventions for a set target. Each score indicates the extent to which the corresponding potential intervention is expected to affect or influence some target variable within the traffic simulation. The target may be, for instance, a reduction of emission output within the geographic region, a reduction in traffic congestion, reducing the time for commuting, cost savings, or optimisation of road capacity. The method may then include selecting the top-scoring potential intervention as the chosen intervention, for application to the simulation. Of course, multiple interventions may be chosen - for example, the top three scoring potential interventions. In this case, the modified traffic simulation may be configured to reflect the effect on traffic as caused by the multiple selected interventions.

Optionally, calculating the plurality of scores corresponding to the plurality of potential interventions is performed via an optimisation process. The optimisation process is configured to solve an optimisation problem for each given potential intervention, minimising (or maximising) an objective function to provide an optimal solution (or as near-to-optimal as feasible given time and processing power constraints). The optimisation process may be configured to some the optimisation problem so as to find the optimal action to take in the real world..

The solution for a potential intervention may be regarded as the score for that potential intervention, which provides a measure of the expected impact of the potential intervention for a given set target (e.g., reduce emission output, reduce traffic congestion, optimise road capacity, etc). The objective function may be representative of, for example, a level of traffic congestion, a monetary value associated with traffic flow (e.g., related to fuel costs for individual drivers), a level of pollutant emission (e.g., from all vehicles in the geographic area in the scope), or a time value associated with traffic flow (e.g., average commute time for all vehicles).

The objective function may be a multi-objective function, where each objective may be optimised simultaneously. That is, there may be multiple set targets for the optimisation process. The score for the intervention in this case may be a weighted average of scores for underlying individual targets. For instance, where the optimisation process is performed in respect of two targets (e.g., reduce overall $CO_2$ emission and reduce the time of commute for vehicle users in the geographic region), the score may be a weighted average of the score calculated for each target. Weighting parameters may be preconfigured, and representative of the "importance" of the target. For example, where it is desired that each of two targets is met, a weighting parameter of 0.5 may be applied to each score; where one target takes precedence over another (e.g., emission output is more "important" than commute time), a weighting parameter of 0.9 may be applied to the one target and 0.1 may be applied to the other target.

Optionally, the intervention may be a constraint or a limitation applied to any or all of the following values or categories: a number of vehicles inside the geographic region (or a sub-region thereof); transport modality inside the geographic region or sub-region (e.g., allowing only buses and taxis on roads and not private vehicles); locations of vehicles inside the geographic region or sub-region (e.g., shutting particular roads); the direction of travel of vehicles inside the geographic region or sub-region (e.g., implementing a contraflow lane reversal); speeds of vehicles inside the geographic region (e.g., implementing a minimum or maximum speed limit); the number of accessible (that is, open) lanes of traffic or roads (e.g., shutting lanes of traffic in a road); the number of accessible stops or stations (e.g., bus stops, train stations, underground stations, tram stops); and the behaviour of traffic lights (e.g., adjusting timing of traffic light changes).

Optionally, the effect of the intervention on traffic may be change or variation of any or all of the following quantities: a number of vehicles inside the geographic region or sub-region; the number of each of a plurality of transport modalities (e.g., the number of cars and the number of buses) inside the geographic region or sub-region; the location of vehicles inside the geographic region or sub-region; the direction (or directions) of travel of vehicles inside the geographic region or sub-region; the speeds of each of a plurality of vehicles inside the geographic region or sub-region; the average speeds of each of the plurality of vehicles inside the geographic region or sub-region; and the minimum speed and/or the maximum speed of each of the plurality of vehicles inside the geographic region or sub-region. The effect of the invention may be a change or variation of any or all of: a level of congestion inside the geographic region or sub-region; a number of traffic jams inside the geographic region or sub-region; a level of use of a road network inside the geographic region or sub-region; a maximum transit capacity inside the geographic region or sub-region; and a level of emission output inside the geographic region or sub-region. The effect of the intervention may be a variation of any or all of the following quantities: the need of additional corridors between an origin and destination; the need of redirection of traffic flow in roads; the addition of lanes in some roads; the addition of roads; and the reduction or inclusion of stops for some transport services (e.g., buses, trains, trams).

Optionally, the method includes a step of accepting input (into the implementing computing means) of historical traffic data for the geographic region. The method may then include a step of executing the traffic simulation, making use of both the traffic data and any historical traffic data. For instance, the simulation may make use historical of vehicular or pedestrian for a given geographic region alongside live data.

Optionally, the traffic data may comprise data obtained from a DT of the geographic region. That is, any sensors may be configured to output sensor data to a DT. A DT in this context is a digital model of the traffic system that serves as the effectively indistinguishable digital counterpart of the traffic system for such purposes as simulation, integration, testing, monitoring, and maintenance of the real-life system.

Optionally, the sensors may be any or all of the following: GPS sensors or antennas; cellular network sensors or antennas; loop sensors or loop detectors, which may register the number of passing vehicles; camera sensors; and vehicle parking sensors. The sensors may be on-board sensors, for example a GPS sensor or cellular (telecommunications) sensor provided within or on a vehicle or pedestrian, configured to transmit the position of the vehicle or pedestrian. Antenna signal triangulation may be used to determine traffic position. Alongside GPS data and cellular data, any other floating car data may be suitably used. Camera sensors may be used to remotely accumulate image data, upon which image processing techniques such as object detection may be used to provide vehicle or pedestrian positioning data. Vehicle parking sensors (either on-board or remote to the vehicle) may be used to indicate the parked position of vehicles, thereby providing, for example, parking facility occupation level.

Optionally, the steps of modifying parameters of the traffic simulation and executing the modified traffic simulation may be performed in parallel with the traffic simulation. In this way, there is no need to stop the ongoing simulation. Rather, the traffic simulation may continue unhindered, thereby offering predictive and adaptive capabilities. The traffic simulation (both the original and the subsequent modified simulation) may be performed in at least real-time, meaning that the simulation's clock runs at least the same speed as a real clock. Advantages may be seen when running the traffic simulation faster than real-time, in which case multiple potential interventions may be investigated and results may be provided to user in a timeframe that allows successful implementation. In one implementation, traffic simulations may be performed 50-times faster than real-time.

Embodiments of another aspect include a data processing apparatus, which comprises a memory and a processor. The memory stores computer-executable instructions to carry out a computer-implemented method for predicting evolution of a traffic simulation. The processor is configured to execute the instructions.

Embodiments of another aspect include a computer program comprising instructions, which, when executed by computer, causes the compute to execute a computer-implemented method for predicting evolution of a traffic simulation.

Embodiments of another aspect include a non-transitory computer-readable storage medium comprising instructions, which, when executed by a computer, cause the computer to execute a computer-implemented method for predicting evolution of a traffic simulation.

The invention may be implemented in digital electronic circuitry, or in computer hardware, firmware, software, or in combinations thereof. The invention may be implemented as a computer program or a computer program product, i.e., a computer program tangibly embodied in a non-transitory information carrier, e.g., in a machine-readable storage device or in a propagated signal, for execution by, or to control the operation of, one or more hardware modules.

A computer program may be in the form of a stand-alone program, a computer program portion, or more than one computer program, and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

The invention is described in terms of particular embodiments. Other embodiments are within the scope of the following claims. For example, the steps of the invention may be performed in a different order and still achieve desirable results.

Elements of the invention have been described using the terms "processor", "input device" The skilled person will appreciate that such functional terms and their equivalents may refer to parts of the system that are spatially separate but combine to serve the function defined. Equally, the same physical parts of the system may provide two or more of the functions defined. For example, separately defined means may be implemented using the same memory and/or processor as appropriate.

Brief Description of the Drawings

Reference is made, by way of example only, to the accompanying drawings in which:

FIGURE 1 is a flowchart of a general method for predicting evolution of a traffic simulation according to embodiments;
FIGURE 2 is a schematic overview of a modular computing architecture, suitable for implementing aspects of the method for predicting evolution of a traffic simulation; and
FIGURE 3 is a flowchart demonstrating the functional stages of a modular computing architecture;
FIGURE 4 is another schematic overview of a modular computing architecture;
FIGURE 5 is a schematic overview of a scope definition sub-module;
FIGURE 6 is a schematic overview of a scope definition component of a scope definition sub-module;
FIGURE 7 is a schematic overview of an intervention selection sub-module;
FIGURE 8 is a schematic overview of an intervention logic component of an intervention selection sub-module;
FIGURE 9 is a schematic overview of an intervention ranking component of an intervention selection sub-module;
FIGURE 10 is a schematic overview of an intervention definition sub-module;
FIGURE 11 is a schematic overview of a simulation decoder module;
FIGURE 12 is a comparison between a conventional technique and a technique according to an embodiments;
FIGURE 13 is a block diagram of computational means for implementation of methods according to embodiments.

## Detailed Description

In a practical use case of a known simulation technique for tackling traffic simulation scenarios, sensor data may be fed to a simulation, which may reproduce a behavioural model (for instance, a traditional ABMS). With such approaches, it is difficult to recreate the behaviour of upcoming scenarios that are not modelled or necessarily notified to the simulation system. For example, sudden increases in pedestrian traffic in areas affected by concerts or other events may not be readily considered with known simulation techniques. New, upcoming scenarios are not noticed and processed by known simulation systems as such systems are not equipped with means to become aware of abnormal upcoming scenarios and are not sufficiently adaptive to adopt new simulation behaviours without the creation of entire new models.

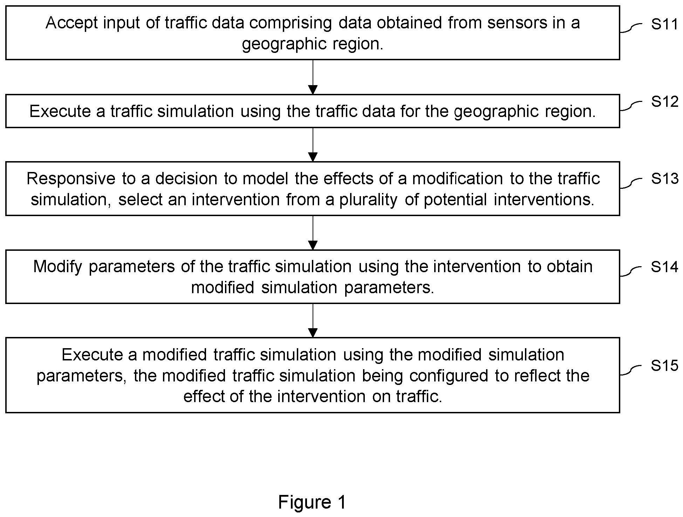

FIGURE 1 is an overview of a general method for predicting evolution of a traffic simulation, which addresses the above-described shortcomings of known simulation techniques. At S11, the computing means that is implementing the general method accepts input of traffic data comprising data obtained from sensors in a geographic region. At S12, the computing means executes a traffic simulation using the traffic data for the geographic region. At S13, responsive to a decision to model the effects of a modification to the traffic simulation, the computing means selects an intervention from a plurality of potential interventions. For example, S13 includes firstly modifying the behaviour of the simulation when notified of, made aware of, or successfully identifying forecasted behaviour at a time increment within the simulation, and S13 includes secondly a responsive selection of an intervention for the simulation, as a countermeasure for the forecasted behaviour. At S14, the computing means modifies parameters of the traffic simulation using the intervention to obtain modified simulation parameters. At S15, the computing means executes a modified traffic simulation using the modified simulation parameters, the modified traffic simulation being configured to reflect the effect of the intervention on traffic.
With the general method for predicting evolution of a traffic simulation and the further techniques herein, known simulation systems may be adapted to become aware of new, upcoming scenarios in early stages. Systems according to embodiments are able to understand the insights from upcoming scenarios, specify new simulation set-ups, and select optimal interventions as a countermeasure. Techniques herein enable in traditional ABMSs to adapt and evolve intentions. Techniques herein provide more realistic simulations aligned with real-world activity.

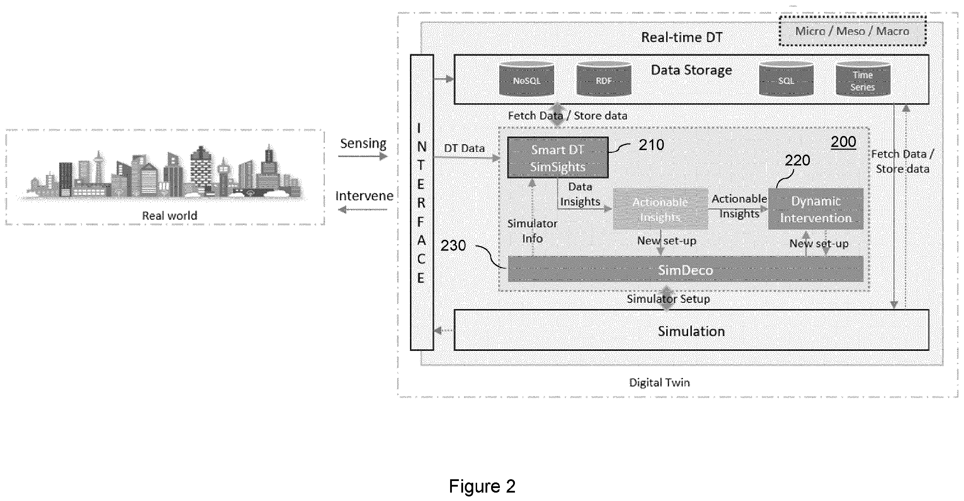

FIGURE 2 is a schematic overview of a modular computing architecture, suitable for implementing aspects of the method for predicting evolution of a traffic simulation. System 200 may communicate with an interface layer to receive live data from sensors in a geographic region of the real world. The interface layer may also be connected with a data storage layer, where data from sensors may be stored over time. The interface layer may also receive historical data, stored in the data storage layer. The data storage layer may include, for example, NoSQL databases, SQL databases, and time series databases.
As shown, system 200 may be a component of a DT and/or may be a component of a real-time DT thereof. The DT may be configured as a microscopic model, a mesoscopic model, a macroscopic model, or any other model granularity. As an example, a microscopic model describes vehicles and pedestrian behaviour with high detail and individually on the traffic stream. A mesoscopic model may not distinguish or trace individual vehicles or pedestrians, but may express the probability of having a given vehicle or pedestrian at a given position, time and velocity. A macroscopic model may represent traffic at a high level of aggregation without distinguishing vehicles or pedestrians individually.

System 200 comprises the following components, which - in an implementation example - provide the following functionality. The Smart DT SimSights module 210 (or insight module) may be in charge of providing insights from sensors and from the data storage layer, which provide real world and historical data. These insights provide information about forecasted values and abnormal behavioural patterns. For that purpose, insight module 210 retrieves information from sensors placed in the real world, from information stored in the persistence layer (data storage), and in the form of simulation information from the SimDeco module 220. Insight module 210 generates data insights. Data insights are collected and aggregated as Actionable Insights, with the aim to provide relevant information to the SimDeco module 220 and Dynamic intervention module 220.

The Dynamic intervention module 220 (or intervention module) generates potential interventions to be applied to the simulation, based on any Actionable Insights received and based on simulator specifications. Intervention module 220 generates or determines the scope of the received data insights based on a set target, such as traffic reduction, emission reduction, etc. Scope in this context refers to the bounds or extent to which any insight covers within the simulation. For example, the scope may be a sub-region of interest of the geographic region simulated, a time period of interest within the simulation, and specific traffic modalities of interest. Intervention module 220 then selects the optimal interventions to be applied to the simulation based on the set target. Intervention module 220 then generates an intervention set-up given all received input (i.e., parameters suitable for implementing the simulation with the intervention). Intervention module 220 then provides any intervention set-up to SimDeco module 230.

The SimDeco module 230 (or simulation decoder module) enables the communication of new set-ups to simulation means, as Actionable Insights or as interventions to be executed, thereby modifying the behaviour of the original simulation. Simulation decoder module 230 modifies technical specifications of the simulation to implement new set-ups and orders. Simulator decoder module 230 sends any simulation and/or intervention parameters or information for executing by a simulation system.

In addition, the simulation system may fetch data from the data storage layer for use in the simulation process. The simulation system may also store data in the data storage layer; for example, the simulation system may output simulated traffic data to be stored for future consultation. Both the simulation system and data storage layer may communicate with the interface layer, in order to acquire and store sensor data.

The system 200 is able to understand forecasted traffic insights, define the scope of the forecasted insights, and select potential interventions. Given a set of potential interventions, system 200 measures intervention impact and selects the optimal intervention (or interventions).

System 200 may be configured to output data or instructions into the real world. For instance, in the event that an intervention is selected, which demonstrates (via simulation) that a target will be met (e.g., congestion reduction, or emission reduction), system 200 may output instructions corresponding to the selected intervention so as to implement the selected intervention within the real traffic system. This could be, for example, instructions to a user (e.g., a traffic authority) to close a road or apply a contraflow arrangement. The instructions may be output in the form of computer-readable instructions, so as to implement the selected intervention without human intervention (e.g., close an electronically controlled gate or display a revised maximum speed limit on smart motorway signage).

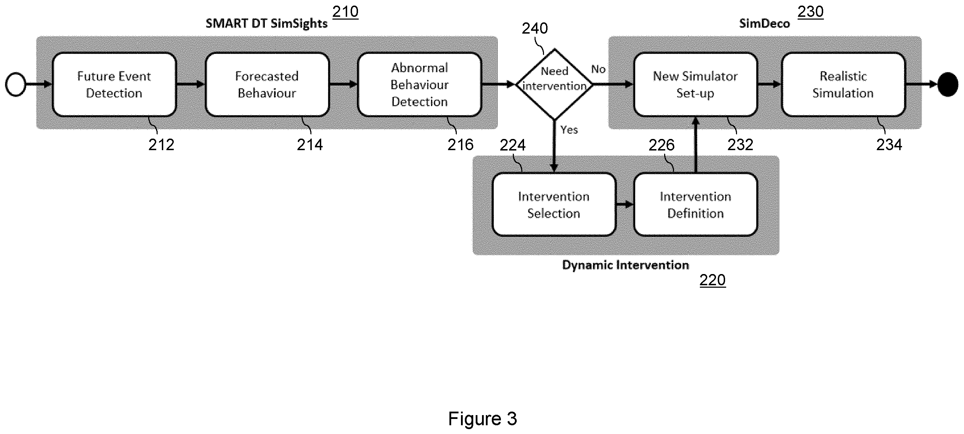

FIGURE 3 is another schematic overview of a modular computing architecture, suitable for implementing aspects of the method for predicting evolution of a traffic simulation. This overview presents the functional stages in a logical flow diagram, including sub-modules for ease of understanding.

Insight module 210 accepts provides insights from the sensors of the real world and - optionally - historical data. Using event detection sub-module 212, insight module 210 detects potential upcoming events, and, using forecast sub-module 214, forecasts any new behaviours Abnormal behaviour detection sub-module 216 detects abnormal behaviour in any forecasted behaviour (an excess in the volume of forecasted traffic relative to a predetermined maximum threshold).

Decision sub-module 240 determines if any detected abnormal traffic behaviour requires addressing through application of an intervention.

When decision sub-module 240 deems it necessary to apply an intervention, control is passed to intervention module 220. Intervention module 220 generates potential interventions based on the inputs received from the insight module. For that purpose, intervention module 220 generates the scope of the data insights received and selects the optimal suitable interventions to be applied based on a specific target, using intervention selection sub-module 224. Intervention definition sub-module 226 generates the intervention set-up (parameters) given any received inputs, which may then be transmitted to simulation decoder module 230.

When decision sub-module 240 deems it unnecessary to apply an intervention (e.g., if the expected effect of detected abnormal behaviour on the traffic is minimal), control may pass to simulation decoder module 230, which nonetheless may modify underlying simulation parameters in view of forecasted behaviour (albeit without any intervention).

Simulation decoder module 230 enables the communication of new or modified simulation parameters, as Actionable Insights (based, e.g., on forecasted behaviour) or as interventions. Using new simulation set-up sub-module 232, the behaviour of the simulation may be modified given the technical specifications of the simulation system in use.

Realistic simulation sub-module 234 sends any new order and simulation parameter details on for execution by the simulation system.

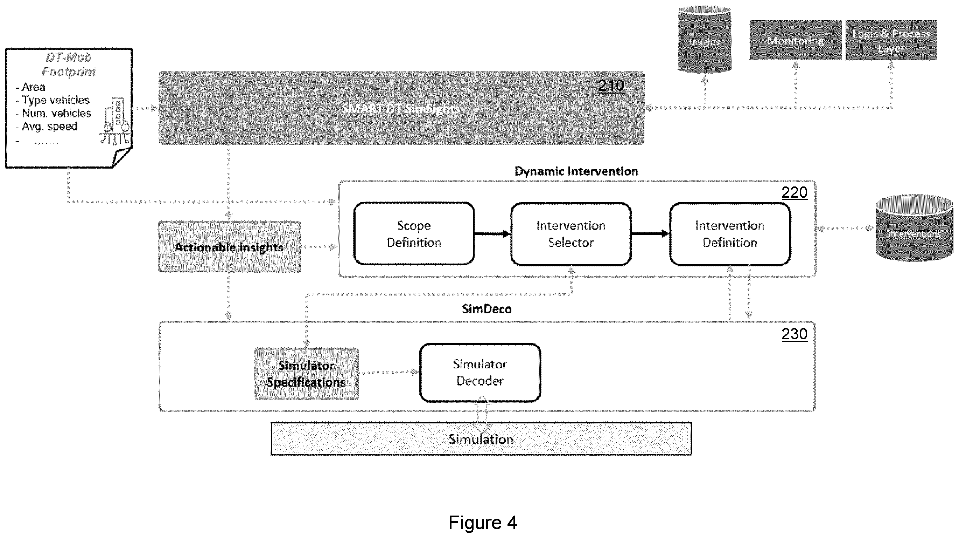

FIGURE 4 is another schematic overview of a modular computing architecture, suitable for implementing aspects of the method for predicting evolution of a traffic simulation. Insight module 210, intervention module 220, and simulator decoder module 230 share the same functionality as described above, which will not be repeated in full here.

Insight module 210 gathers information from sensors placed in the real world. To this end, the insight module 210 accepts information in the form of a DT-Mob footprint, which provides all the information required from the DT. The DT-Mob footprint represents data that may be received from a DT of a geographical area and may include any of vehicle counts, types of vehicles, speed, average speed, maximum speed, minimum speed, level of congestion, traffic jams (number of), the level of use of the road network, maximum transit capacity, weather conditions, presence of a prearranged event (such as a concert, sporting event). Each of the data may be provided as a time series.

The sensor data is processed and a set of Actionable Insights are provided as an output. These Actionable Insights provide information for new or abnormal upcoming events. The Actionable Insights provide information about forecasted behaviours for mobility and about abnormal patterns detected in the near future. Insight module 210 may be communicatively coupled with a persistence layer, where data and insights are stored together with pre-processed information.

Any system that is capable of acquiring sensor data and performing traffic forecasting and abnormal behaviour detection is suitable for implementation as insight module 210. The reader is directed to European Patent Application No. 23382595.9 and European Patent Application No. 23382594.2 for two representative examples of suitable systems.

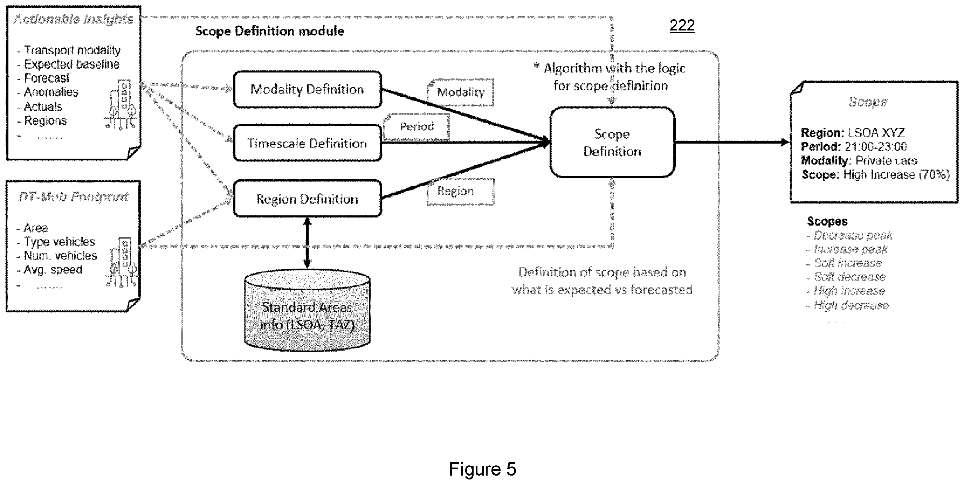

Intervention module 220 generates potential interventions to be applied dynamically in the simulation, based on Actionable Insights and based on the DT-Mob footprint. The scope definition sub-module 222 defines the scope affected by the given Actionable Insights. FIGURE 5 is a schematic overview of scope definition sub-module 222. The scope may be defined using distinct components for modality, timescale, and region for a given Actionable Insights and the DT-Mob footprint.

The region definition may be supplemented using a Knowledge Base (KB), where regional information may be standardised as required. For instance, pre-defined sub-regions may be stored as lower layer super output areas (LSOAs) or traffic analysis zones (TAZs).

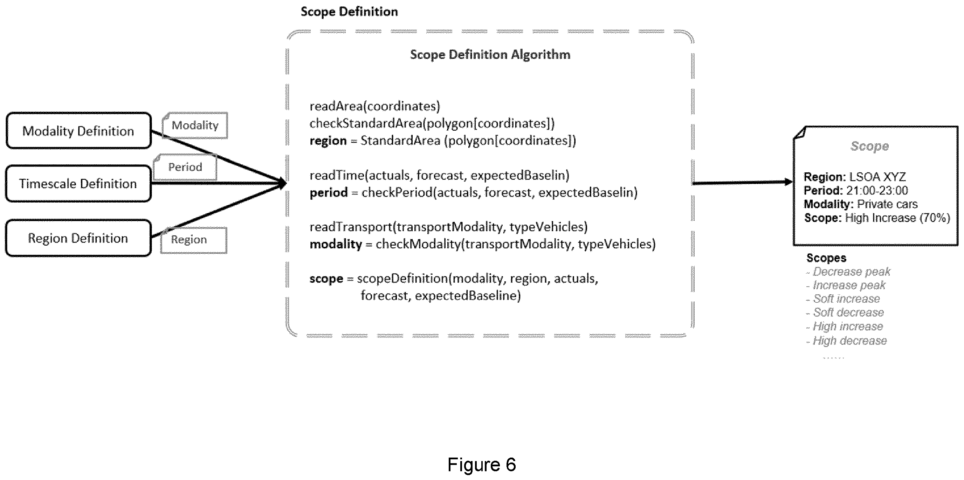

The output of the distinct components of the scope definition sub-module 222 may be used as input into a scope definition component, where the scope definition may be quantified based on different factors, including the type of transport, the affected area, and/or the period. FIGURE 6 provides an example scope definition component and includes pseudo-code demonstrating the functioning thereof. For an input region, period, and modality, the scope may be defined via comparison of the given area with a standard region (provided in the form of polygon coordinates) and via the period and traffic modality of interest.

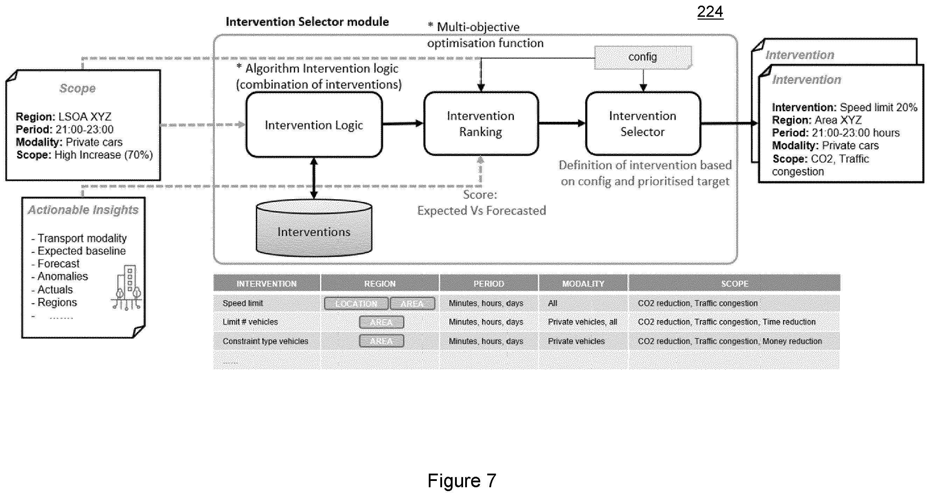

The scope may be output as a machine readable data file (for example an XML file) as displayed, including distinct elements for the region of the scope, the period of the scope, the modality of the scope, and the scope of the scope (or the impact of the scope, such as the expected increase in activity of the modality within the region and within the period). Other example impacts are illustrated and include: a decrease peak (e.g., activity is expected to fall before rising); an increase peak (e.g., activity is expected to rise before falling); a soft increase (e.g., activity expected to rise >0% and <50%); a soft decrease (e.g., activity expected to fall >0% and <50%); a high increase (e.g., activity expected to rise >50%); and a high decrease (e.g., activity expected to fall >50%). Of course, other definitions of scope impacts are possible. Intervention selector sub-module 224 of intervention module 220 selects the optimal intervention or set of interventions given a scope and given the Actionable Insights, determined through optimisation of some target function. FIGURE 7 is a schematic overview of intervention selector sub-module 224. An intervention logic component may be communicatively coupled to a KB, where prestored potential intervention definitions may be stored. Each potential intervention entry within the KB provides information about: a label, defining the intervention; the region where the intervention may be applied; periods while the intervention may be applied; transport modalities in which the intervention may be applied; and the scope (impact) of intervention.

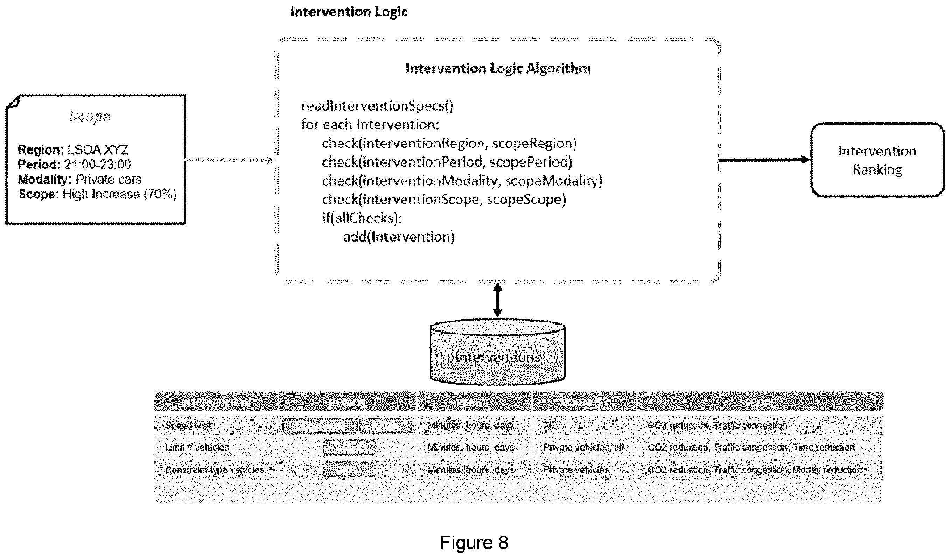

FIGURE 8 provides an example intervention logic component and includes pseudo-code demonstrating the functioning thereof. In effect, the intervention logic component filters all stored potential interventions to identify potential interventions that are suitable given the scope. For instance, given a modality element limiting the scope to private cars, only interventions that relevant to private cars may be returned (e.g., excluding pedestrian-only interventions).

All (filtered) potential interventions are passed to an intervention ranking component, where interventions are scored in respect of their expected impact on the traffic simulation. This score is determined by optimising an objective function or variable. The target function may be, for example, demonstrative of a level of traffic congestion, a monetary value associated with traffic flow (e.g., related to fuel costs for individual drivers), a level of pollutant emission (e.g., from all vehicles in the geographic area in the scope), or a time value associated with traffic flow (e.g., average commute time for all vehicles).

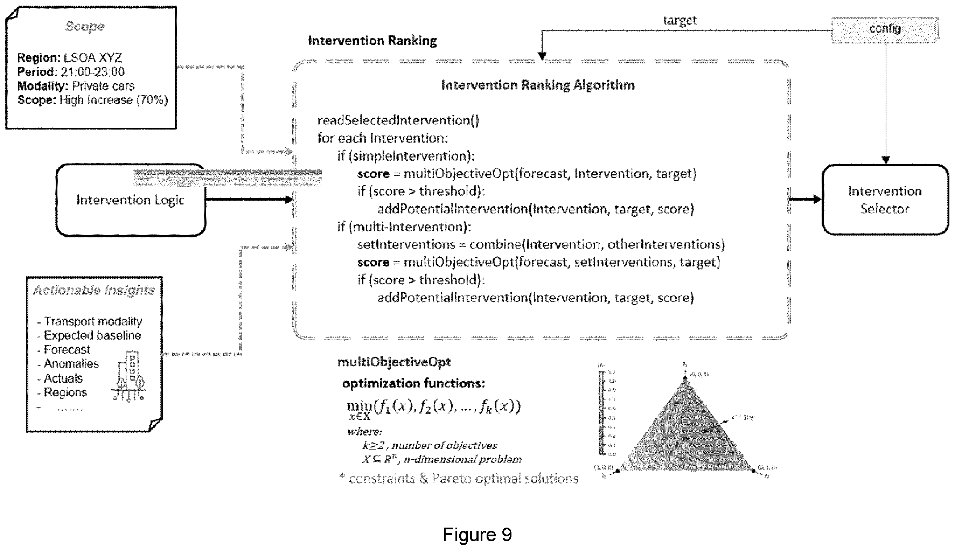

FIGURE 9 provides an example intervention ranking component and includes pseudo-code demonstrating the functioning thereof. The underlying algorithm reads all the (filtered) potential intervention and solves or optimises a multi-objective optimisation problem (or Pareto optimisation problem), one objective per target function. Expression 1 provides a general structure for such a multi-objective optimisation problem:

$$\min_{x \in X}\left(f_1(x), f_2(x), \dots, f_k(x)\right) \qquad \text{(Exp. 1)}$$

where $f_i(x)$ is the objective function for objective $i$, $k$ is the number of objectives, and $X \subseteq R^n$ denotes the problem is an n-dimensional problem. Of course, the optimisation problem may instead be formulated as a maximisation (rather than a minimisation) problem.

For the application of the optimisation function, forecasted values, parameters needed for the application of the intervention, and the defined target may be used, with the aim of optimising the chosen objective function(s). The optimisation function provides a set of scores, indicative of the total expected impact of each potential intervention. The intervention ranking component is able to score simple, isolated interventions and is able to scope combinations of multiple interventions, for example, using a weighting applied to the scores of distinct interventions.

Given a multi-objective optimisation problem, one may consider a set of equations where there are a set of variables that - depending on the set target (e.g., reduce emission, reduce commute time) - are weighted or scored in different ways. For example, the score may be different if the target is set as "traffic reduction", "maximise the number of vehicles in the road without traffic jam", "pollution reduction", or "reducing travel time". The elements of the objective function ($x$ in expression 1, above) may be the number of vehicle of distinct vehicle modality (car, van, etc.), the speed for each type of vehicle, the number of passengers, etc. The behaviours are expressed as a set of functions, where the purpose is to maximise the score (or minimise the score, depending on the set target).

While a single objective optimisation problem is also feasible in this context, a single objective function may only enable optimisation for a single target. With a multi-objective optimisation problem, all targets may be optimised.

An intervention selector component filters and selects the optimal intervention (or interventions) based on the set of impact score. For instance, a configuration parameter may be configured so as to cause the implementing computing means to select the top scoring intervention (or, equivalently, the lowest scoring intervention in the event a low score indicates a positive expected effect of an intervention). Of course, the computing means may be configured to select multiple interventions.

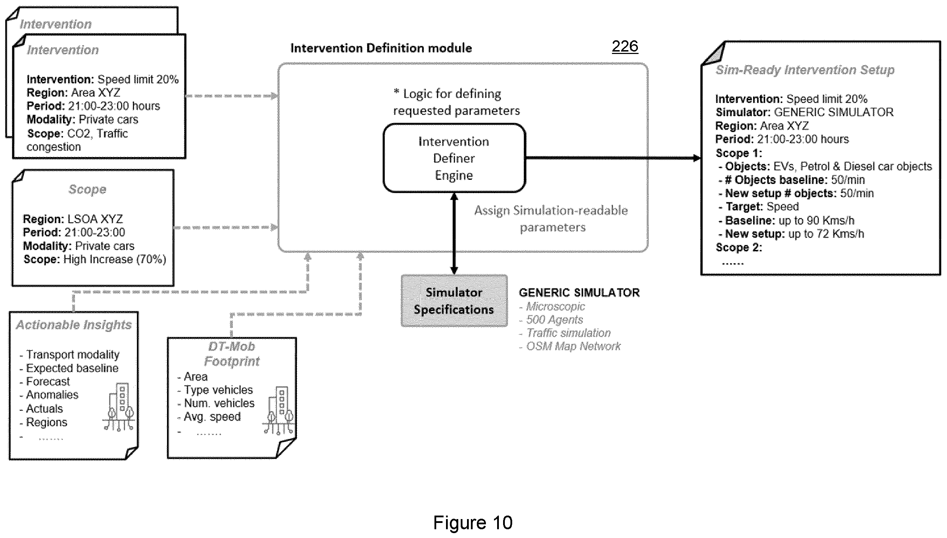

Intervention definition sub-module 226 of intervention module 220 generates the intervention set-up or configuration, with sufficient details so as to be interpretable by the simulation system. FIGURE 10 is a schematic overview of intervention definition sub-module 226. As inputs, the intervention definition sub-module 226 accepts the selected intervention and optionally accepts the scope definition, any Actionable Insights, and the DT-Mob footprint. In addition to these sources, the intervention definition sub-module 226 may accept input of specifications of the simulation system used (e.g., an indication that the simulation is a microscopic simulation, using 500 agents, is configured to simulate traffic, and makes uses of OpenSteetMap (OSM) maps).

The intervention definition sub-module 226 constructs generic information in the form of a pseudo-simulation specification. The pseudo-simulation specification is configured to be supplement concrete features of a simulation set-up, and includes, for example, the type of objects to be simulated, the baseline for the number and the speed of objects to be simulated, the updated values for the number and speed of objects to be simulated, the target, etc. In this way, an intervention definer engine component generates new simulation specifications or configurations based on intervention targets, the scope of the intervention, the potential future values, and the current (baseline) values.

The intervention definer engine component outputs the pseudo-simulation specification, ready for implementation by the simulation decoder module 230.

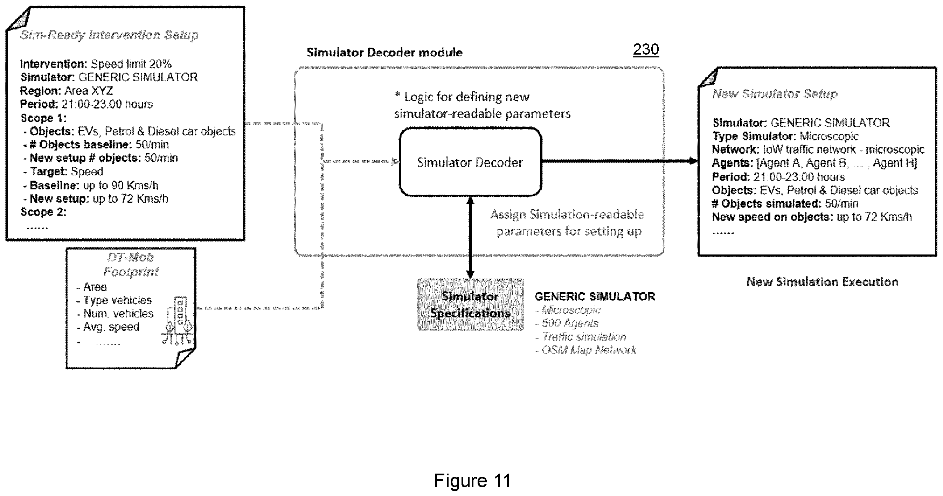

FIGURE 11 is a schematic overview of simulation decoder module 230. Simulation decoder module 230 enables the communication of the pseudo-simulation specification to the simulation system. A simulator decoder component of the simulation decoder module 230 accepts as input the pseudo-simulation specification and optionally the DT-Mob Footprint, and decodes or translates the pseudo-simulation specification into parameters suitable for implementation by the simulation system in use (the "new simulator setup").

The simulator decoder component may incorporate any other additional parameters required for the set-up of the simulation system, such as, the network used for the simulation, agent details, etc.

The exact format and structure of the new simulator setup will vary depending on the simulation system in use (as indicated by the use of "GENERIC SIMULATOR" in the present example). Suitable examples of simulation system include the proprietary software AnyLogic (developed by The AnyLogic Company), the open-source transportation modelling and simulation toolbox TRANSIMS, the open-source microscopic and continuous multi-modal simulation package Simulation of Urban MObility, SUMO, (developed by the German Aerospace Center), FlameGPU (developed by Richmond, P. *et al,* doi: 10.5281/ZENODO.5428984), and proprietary software Junctions (developed by Transport Research Laboratory). The skilled reader will appreciate that there are many suitable simulation systems, depending on the purpose.

As seen throughout the present example, a data processing apparatus that implements the method for predicting evolution of a traffic simulation may be configured in terms of functional units or modules. Such units or modules may comprise processing circuitry configured to perform the role of the above-described insight module 210, intervention module 220, simulation decoder module 230, and sub-modules and components thereof. System 200 may be configured as an application programming interface, enabling communication between at least the real world sensors and the chosen simulation system.

In one example, the system 200 may be implemented using a combination of object-oriented programming languages Python (used, for example, for the multi-objective optimisation process) and Java (largely for back-end logic, including interfacing with any KB).

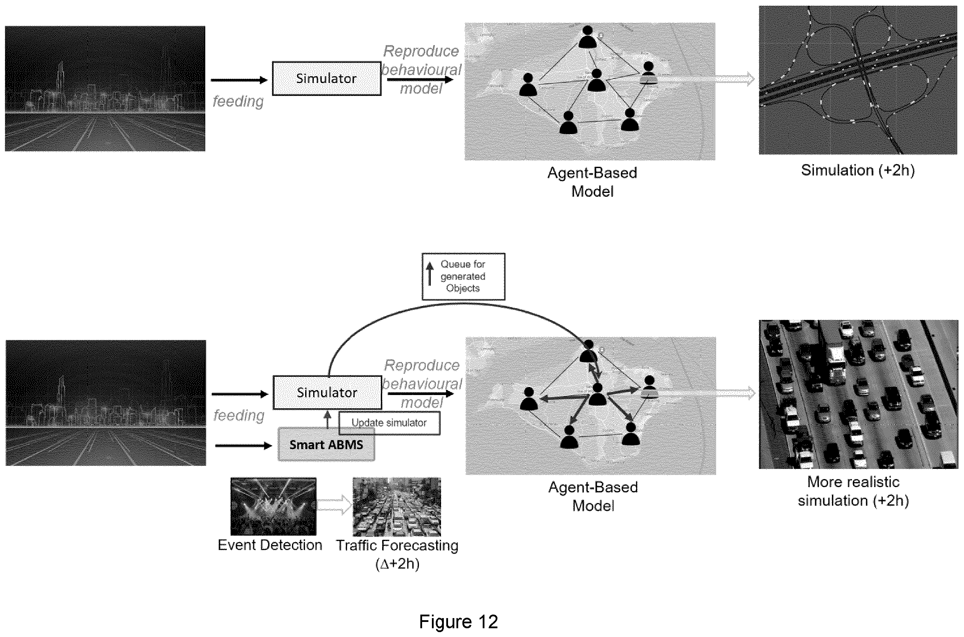

FIGURE 12 is a comparison between a conventional ABMS (upper) and an AMBS supplemented with techniques according to embodiments (lower). A conventional ABMS accepts sensor data, fed from the real world, into a simulation system and reproduces agent behaviour into an agent-based model. As an example, the agent-based model may then yield a simulation advanced 2 hours from real time at a relatively low level of precision and accuracy.

An ABMS supplemented with techniques herein instead accepts sensor data and performs event detection so as to arrive at a traffic forecast. In this example, the forecast is advanced 2 hours from real time; this process may be performed in faster than real time, such that there is no delay in providing any recommended intervention. The simulation system may then be updated with information concerning a selected intervention and reproduces modified behaviour into an agent-based model. The modified agent-based model may then yield a simulation advanced 2 hours from real time (corresponding to the timeframe as used in the selection of an intervention) at a relatively high level of precision and accuracy.

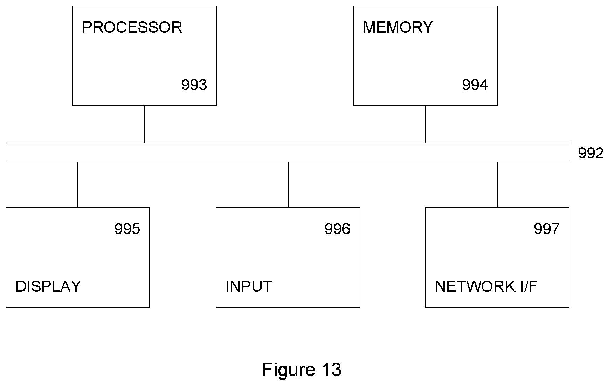

FIGURE 13 is a block diagram of a computing device, such as a data processing server, which embodies the present invention, and which may be used to implement a method for predicting evolution of a traffic simulation. The computing device comprises a processor 993 and memory, 994. Optionally, the computing device also includes a network interface 997 for communication with other computing devices, for example with other data storage devices or external data processing devices. An embodiment may be composed of a network of such computing devices.

Optionally, the computing device also includes one or more input mechanisms such as keyboard and mouse 996, and a display unit such as one or more monitors or screens 995. The components are connectable to one another via a bus 992.

The memory 994 may include a computer readable medium, a term which may refer to a single medium or multiple media (e.g., a centralised or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing code stored in the memory to implement the method for predicting evolution of a traffic simulation and the associated simulation described here and in the claims. The memory 994 stores data being read and written by the processor 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an ASIC, a FPGA, a digital signal processor (DSP), network processor, or the like. In one or more embodiments, a processor is configured to execute instructions for performing the operations and steps discussed herein.

Display 995 may display a user interface. Input 996, in the form of a touchscreen or screen and keyboard and/or voice, may be used for user input. The user interface may be embodied as a user application shown on the display and optionally connected to the audio input/output of the user device for voice input and audio output. Local storage, for example of simulation parameters or of predetermined potential interventions, may be provided by memory 994, and processor 993 may carry out background functions. The core functionality (selection of an intervention, for example) may preferably be implemented remotely from the user device, for example on the cloud.

The network interface (network I/F) 997 may be connected to a network, such as the internet, and is connectable to other such computing devices via the network. The network I/F 997 may control data input/output from/to other apparatus via the network. Other peripheral devices such as microphone, speakers, etc. may be included in the computing device.

An insight module 210 may be a processor 993 (or plurality thereof) executing instructions stored on a portion of the memory 994 and exchanging data via network I/F 997. In particular, processor 993 executes processing instructions to retrieve traffic data from sensors and identifies and analyses any upcoming events in the traffic system likely to require intervention.

An intervention module 220 may be a processor 993 (or plurality thereof) executing instructions stored on a portion of the memory 994 and exchanging data via network I/F 997. In particular, processor 993 executes processing instructions to determine the scope of the traffic simulation to be subject to an intervention and select an intervention (or interventions).

A simulation decoder module 230 may be a processor 993 (or plurality thereof) executing instructions stored on a portion of the memory 994 and exchanging data via network I/F 997. In particular, processor 993 executes processing instructions to implement intervention parameters within a data structure that is readable by the given simulation system.

Processors 993 embodying insight module 210, intervention module 220, and simulation decoder module 230 may execute instructions stored on a portion of the memory 994 to exchange data between modules via bus 992 to via network I/F 997 to external entities, such as traffic sensors.

Methods embodying the present invention may be carried out on a computing device such as that illustrated in FIGURE 13. Such a computing device need not have every component illustrated in FIGURE 13, and may be composed of a subset of those components. Methods embodying the present invention may be carried out by a single computing device in communication with one or more data storage servers via a network. The computing device may be a data storage itself storing preconfigured interventions, buffered sensor data, historical sensor data, multi-function optimisation models and parameters, etc.

A method embodying the present invention may be carried out by a plurality of computing devices operating in cooperation with one another. One or more of the plurality of computing devices may be a data storage server storing at least a portion of preconfigured interventions, buffered sensor data, historical sensor data, multi-function optimisation models and parameters, etc c.

The various methods described above may be implemented by a computer program. The computer program may include computer code (e.g., instructions) arranged to instruct a computer to perform the functions of one or more of the various methods described above. For example, the steps of the methods described in relation to FIGURE 1 may be performed by the computer code. The steps of the methods described above may be performed in any suitable order. The computer program and/or the code for performing such methods may be provided to an apparatus, such as a computer, on one or more computer readable media or, more generally, a computer program product. The computer readable media may be transitory or non-transitory. The one or more computer readable media could be, for example, an electronic, magnetic, optical, electromagnetic, infrared, or semiconductor system, or a propagation medium for data transmission, for example for downloading the code over the Internet. Alternatively, the one or more computer readable media could take the form of one or more physical computer readable media such as semiconductor or solid state memory, magnetic tape, a removable computer diskette, a random access memory (RAM), a read-only memory (ROM), a rigid magnetic disc, and an optical disk, such as a CD-ROM, CD-R/W or DVD. The instructions may also reside, completely or at least partially, within the memory 994 and/or within controller circuitry of processor 993 during execution thereof by the computing system, the memory 993 and the controller circuitry of processor 993 also constituting computer-readable storage media.

In an implementation, the modules, components and other features described herein may be implemented as discrete components or integrated in the functionality of hardware components such as ASICS, FPGAs, DSPs or similar devices.

A "hardware component" is a tangible (e.g., non-transitory) physical component (e.g., a set of one or more processors) capable of performing certain operations and may be configured or arranged in a certain physical manner. A hardware component may include dedicated circuitry or logic that is permanently configured to perform certain operations. A hardware component may comprise a special-purpose processor, such as an FPGA or an ASIC. A hardware component may also include programmable logic or circuitry that is temporarily configured by software to perform certain operations.

In addition, the modules and components may be implemented as firmware or functional circuitry within hardware devices. Further, the modules and components may be implemented in any combination of hardware devices and software components, or only in software (e.g., code stored or otherwise embodied in a machine-readable medium or in a transmission medium).

Unless specifically stated otherwise, as apparent from the following discussion, it is appreciated that throughout the description, discussions utilizing terms such as "receiving", "determining", "comparing", "enabling", "maintaining", "identifying", "obtaining", "accessing", or the like, refer to the actions and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of methods and apparatus described herein may be made.

## Claims

1. A computer-implemented method for predicting evolution of a traffic simulation, the method comprising:

   accepting input of traffic data comprising data obtained from sensors in a geographic region;
   executing a traffic simulation using the traffic data for the geographic region;
   responsive to a decision to model the effects of a modification to the traffic simulation, selecting an intervention from a plurality of potential interventions;
   modifying parameters of the traffic simulation using the intervention to obtain modified simulation parameters; and
   executing a modified traffic simulation using the modified simulation parameters, the modified traffic simulation being configured to reflect the effect of the intervention on traffic.

2. The method according to claim 1, wherein the decision to model the effects of the modification to the traffic simulation comprises:

   identifying an upcoming event in the traffic simulation;
   forecasting the impact of the upcoming event on the traffic simulation; and
   when the impact exceeds a predetermined threshold, deciding to model the effects of the modification to the traffic simulation.

3. The method according to claim 1 or claim 2, wherein selecting the intervention from the plurality of potential interventions comprises:

   determining the scope of the traffic simulation to be subject to the intervention;
   calculating a plurality of scores corresponding to the plurality of potential interventions, the scores indicating the extent to which the corresponding potential intervention affects a target variable for the traffic simulation; and
   selecting the top-scoring potential intervention as the intervention.

4. The method according to claim 3, wherein calculating the plurality of scores corresponding to the plurality of potential interventions comprises performing an optimisation process configured to solve an optimisation problem in respect of the potential intervention.

5. The method according to claim 3 or claim 4, wherein the scope of the traffic simulation to be subject to the intervention comprises any or all of: traffic modality; timescale; and sub-region of the geographic region.

6. The method according to any preceding claim, wherein the intervention is a constraint on any or all of the following:

   a number of vehicles inside the geographic region;
   transport modality inside the geographic region;
   locations of vehicles inside the geographic region;
   directions of travel of vehicles inside the geographic region;
   speeds of vehicles inside the geographic region;
   a number of accessible lanes and/or roads;
   a number of accessible stops and/or stations; and
   traffic light behaviour.

7. The method according to any preceding claim, comprising selecting multiple interventions from the plurality of potential interventions.

8. The method according to any preceding claim, wherein the effect of the intervention on traffic is variation of any or all of the following:

a number of vehicles inside the geographic region;
numbers of each of a plurality of transport modalities inside the geographic region;
locations of vehicles inside the geographic region;
directions of travel of vehicles inside the geographic region;
speeds of vehicles inside the geographic region;
average speeds of vehicles inside the geographic region;
minimum and/or maximum speeds of vehicles inside the geographic region;
a level of congestion inside the geographic region;
a number of traffic jams inside the geographic region;
a level of use of a road network inside the geographic region;
a maximum transit capacity inside the geographic region; and
a level of emission output inside the geographic region.

9. The method according to any preceding claim, further comprising:

accepting input of historical traffic data for the geographic region; and
executing the traffic simulation using the traffic data and the historical traffic data.

10. The method according to any preceding claim, wherein the traffic data comprises data obtained from a digital twin of the geographic region.

11. The method according to any preceding claim preceding claim, wherein the sensors are any or all of the following:

GPS sensors or antennas;
cellular network sensors or antennas;
loop sensors;
camera sensors; and
vehicle parking sensors.

12. The method according to any preceding claim, wherein modifying parameters of the traffic simulation and executing the modified traffic simulation are performed in parallel with the traffic simulation.

13. A data processing apparatus comprising:

a memory storing computer-executable instructions to carry out the method of any of claims 1 to 13; and
a processor configured to execute the instructions.

14. A computer program comprising instructions that, when the program is executed by a computer, cause the computer to carry out the method of any of claims 1 to 13.

15. A computer-readable medium comprising instructions that, when executed by a computer, cause the computer to carry out the method of any of claims 1 to 13.

Accept input of traffic data comprising data obtained from sensors in a geographic region. — S11

Execute a traffic simulation using the traffic data for the geographic region. — S12

Responsive to a decision to model the effects of a modification to the traffic simulation, select an intervention from a plurality of potential interventions. — S13

Modify parameters of the traffic simulation using the intervention to obtain modified simulation parameters. — S14

Execute a modified traffic simulation using the modified simulation parameters, the modified traffic simulation being configured to reflect the effect of the intervention on traffic. — S15

Figure 1

Figure 2

**SMART DT SimSights** 210

**SimDeco** 230

240

Future Event Detection

Forecasted Behaviour

Abnormal Behaviour Detection

Need intervention

No

Yes

New Simulator Set-up

Realistic Simulation

212      214      216    224      226    232      234

Intervention Selection

Intervention Definition

**Dynamic Intervention**
220

Figure 3

Figure 4

Figure 5

EP 4 567 765 A1

**Scope Definition**

**Scope Definition Algorithm**

readArea(coordinates)
checkStandardArea(polygon[coordinates])
**region** = StandardArea (polygon[coordinates])

readTime(actuals, forecast, expectedBaselin)
**period** = checkPeriod(actuals, forecast, expectedBaselin)

readTransport(transportModality, typeVehicles)
**modality** = checkModality(transportModality, typeVehicles)

**scope** = scopeDefinition(modality, region, actuals,
                   forecast, expectedBaseline)

Modality Definition

Modality

Timescale Definition

Period

Region Definition

Region

*Scope*

**Region:** LSOA XYZ
**Period:** 21:00-23:00
**Modality:** Private cars
**Scope:** High Increase (70%)

**Scopes**
- *Decrease peak*
- *Increase peak*
- *Soft increase*
- *Soft decrease*
- *High increase*
- *High decrease*

Figure 6

**Intervention Selector module**

224

Scope

**Region:** LSOA XYZ
**Period:** 21:00-23:00
**Modality:** Private cars
**Scope:** High Increase (70%)

* Multi-objective
optimisation function

config

* Algorithm Intervention logic
(combination of interventions)

Intervention Logic

Intervention Ranking

Intervention Selector

Definition of intervention based
on config and prioritised target

Score:
Expected Vs Forecasted

Interventions

Intervention

Intervention

**Intervention:** Speed limit 20%
**Region:** Area XYZ
**Period:** 21:00-23:00 hours
**Modality:** Private cars
**Scope:** CO2, Traffic
congestion

Actionable Insights

- Transport modality
- Expected baseline
- Forecast
- Anomalies
- Actuals
- Regions
~ ........

| INTERVENTION | REGION | | PERIOD | MODALITY | SCOPE |
|---|---|---|---|---|---|
| Speed limit | LOCATION | AREA | Minutes, hours, days | All | CO2 reduction, Traffic congestion |
| Limit # vehicles | AREA | | Minutes, hours, days | Private vehicles, all | CO2 reduction, Traffic congestion, Time reduction |
| Constraint type vehicles | AREA | | Minutes, hours, days | Private vehicles | CO2 reduction, Traffic congestion, Money reduction |
| ...... | | | | | |

Figure 7

EP 4 567 765 A1

**Intervention Logic**

**Scope**

**Region:** LSOA XYZ
**Period:** 21:00-23:00
**Modality:** Private cars
**Scope:** High Increase (70%)

**Intervention Logic Algorithm**

```
readInterventionSpecs()
for each Intervention:
    check(interventionRegion, scopeRegion)
    check(interventionPeriod, scopePeriod)
    check(interventionModality, scopeModality)
    check(interventionScope, scopeScope)
    if(allChecks):
        add(Intervention)
```

Intervention Ranking

Interventions

| INTERVENTION | REGION | | PERIOD | MODALITY | SCOPE |
|---|---|---|---|---|---|
| Speed limit | LOCATION | AREA | Minutes, hours, days | All | CO2 reduction, Traffic congestion |
| Limit # vehicles | | AREA | Minutes, hours, days | Private vehicles, all | CO2 reduction, Traffic congestion, Time reduction |
| Constraint type vehicles | | AREA | Minutes, hours, days | Private vehicles | CO2 reduction, Traffic congestion, Money reduction |
| ...... | | | | | |

Figure 8

EP 4 567 765 A1

**Scope**

**Region:** LSOA XYZ
**Period:** 21:00-23:00
**Modality:** Private cars
**Scope:** High Increase (70%)

Intervention Logic

**Actionable Insights**

- Transport modality
- Expected baseline
- Forecast
- Anomalies
- Actuals
- Regions
- .......

target

config

**Intervention Ranking**

**Intervention Ranking Algorithm**

```
readSelectedIntervention()
for each Intervention:
    if (simpleIntervention):
        score = multiObjectiveOpt(forecast, Intervention, target)
        if (score > threshold):
            addPotentialIntervention(Intervention, target, score)
    if (multi-Intervention):
        setInterventions = combine(Intervention, otherInterventions)
        score = multiObjectiveOpt(forecast, setInterventions, target)
        if (score > threshold):
            addPotentialIntervention(Intervention, target, score)
```

Intervention Selector

**multiObjectiveOpt**

**optimization functions:**

$$\min_{x \in X}(f_1(x), f_2(x), \ldots, f_k(x))$$

*where:*
*$k \geq 2$, number of objectives*
*$X \subseteq R^n$, n-dimensional problem*

\* constraints & Pareto optimal solutions

Figure 9

Figure 10

EP 4 567 765 A1

**Sim-Ready Intervention Setup**

**Intervention:** Speed limit 20%
**Simulator:** GENERIC SIMULATOR
**Region:** Area XYZ
**Period:** 21:00-23:00 hours
**Scope 1:**
- **Objects:** EVs, Petrol & Diesel car objects
- **# Objects baseline:** 50/min
- **New setup # objects:** 50/min
- **Target:** Speed
- **Baseline:** up to 90 Kms/h
- **New setup:** up to 72 Kms/h
**Scope 2:**
 ......

**DT-Mob Footprint**
- Area
- Type vehicles
- Num. vehicles
- Avg. speed
- .......

**Simulator Decoder module**                                    230

\* Logic for defining new simulator-readable parameters

Simulator Decoder

Assign Simulation-readable parameters for setting up

**Simulator Specifications**

**GENERIC SIMULATOR**
- Microscopic
- 500 Agents
- Traffic simulation
- OSM Map Network

**New Simulator Setup**

**Simulator:** GENERIC SIMULATOR
**Type Simulator:** Microscopic
**Network:** IoW traffic network - microscopic
**Agents:** [Agent A, Agent B, ... , Agent H]
**Period:** 21:00-23:00 hours
**Objects:** EVs, Petrol & Diesel car objects
**# Objects simulated:** 50/min
**New speed on objects:** up to 72 Kms/h
......

**New Simulation Execution**

Figure 11

Figure 12

```
┌─────────────────────┐          ┌─────────────────────┐
│ PROCESSOR           │          │ MEMORY              │
│                     │          │                     │
│              993    │          │              994    │
└──────────┬──────────┘          └──────────┬──────────┘
           │                                │
───────────┴────────────────────────────────┴───────────────
                                                          992
───┬──────────────────────────┬─────────────────────┬───────
   │                          │                     │
┌──┴───────────────┐   ┌──────┴───────────┐  ┌──────┴──────────┐
│           995    │   │           996    │  │          997    │
│                  │   │                  │  │                 │
│ DISPLAY          │   │ INPUT            │  │ NETWORK I/F     │
└──────────────────┘   └──────────────────┘  └─────────────────┘
```

Figure 13

26

## EUROPEAN SEARCH REPORT

**Application Number**

EP 23 38 3257

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/230540 A1 (HOWELL SHAUN [GB] ET AL) 21 July 2022 (2022-07-21) * paragraphs [0015], [0017], [0018], [0024] – [0039], [0045], [0049], [0055], [0064], [0070], [0075] * | 1-9, 12-15 | INV. G08G1/01 G06F30/20 |
| X | US 2023/097373 A1 (D'ANDRE NICHOLAS [US]) 30 March 2023 (2023-03-30) * paragraphs [0013], [0482] – [0510], [0597]; claims 15-19 * | 1,6,8-15 | |
| A | US 2022/058944 A1 (JHA SANJIV KUMAR [IN] ET AL) 24 February 2022 (2022-02-24) * paragraph [0066] * | 1-15 | |
| A | WO 2023/022136 A1 (NEC CORP [JP]) 23 February 2023 (2023-02-23) * paragraphs [0030] – [0032], [0051]; claims 5-7, 12-15 * | 1-15 | |
| A | WO 2023/031926 A2 (ITC INTELLIGENT TRAFFIC CONTROL LTD [IL]) 9 March 2023 (2023-03-09) * pages 28-30 * | 1-15 | **TECHNICAL FIELDS SEARCHED (IPC)** G08G G06F G01C |
| A | US 2014/278052 A1 (SLAVIN HOWARD [US] ET AL) 18 September 2014 (2014-09-18) * paragraphs [0082] – [0085] * | 1-15 | |

The present search report has been drawn up for all claims

| Place of search | Date of completion of the search | Examiner |
|---|---|---|
| The Hague | 30 April 2024 | Datondji, Sokèmi |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 38 3257

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2024

| Patent document cited in search report | | Publication date | Patent family member(s) | | Publication date |
|---|---|---|---|---|---|
| US 2022230540 | A1 | 21-07-2022 | AU | 2020268854 A1 | 25-11-2021 |
| | | | CA | 3139377 A1 | 12-11-2020 |
| | | | EP | 3966796 A1 | 16-03-2022 |
| | | | GB | 2583747 A | 11-11-2020 |
| | | | US | 2022230540 A1 | 21-07-2022 |
| | | | WO | 2020225523 A1 | 12-11-2020 |
| US 2023097373 | A1 | 30-03-2023 | US | 2023097373 A1 | 30-03-2023 |
| | | | US | 2023098483 A1 | 30-03-2023 |
| US 2022058944 | A1 | 24-02-2022 | NONE | | |
| WO 2023022136 | A1 | 23-02-2023 | NONE | | |
| WO 2023031926 | A2 | 09-03-2023 | NONE | | |
| US 2014278052 | A1 | 18-09-2014 | CN | 105074793 A | 18-11-2015 |
| | | | EP | 2973494 A1 | 20-01-2016 |
| | | | JP | 2016513805 A | 16-05-2016 |
| | | | KR | 20150128712 A | 18-11-2015 |
| | | | US | 2014278052 A1 | 18-09-2014 |
| | | | US | 2018299290 A1 | 18-10-2018 |
| | | | WO | 2014152554 A1 | 25-09-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 23382595
- EP 23382594